# EUROPEAN PATENT SPECIFICATION

(11) **EP 2 108 617 B1**
(45) Date of publication and mention of the grant of the patent: **08.02.2012**
(21) Application number: 09157884.9
(22) Date of filing: 14.04.2009
(51) Int. Cl.: B01J 4/00, C23C 16/22, C23C 16/448, H01L 21/00, F16L 19/02

(54) **Reagent dispensing apparatus**
Reagenzabgabevorrichtung
Appareil distributeur de réactif

(30) Priority: 11.04.2008 US 44083 P; 19.03.2009 US 407376
(43) Date of publication of application: 14.10.2009
(73) Proprietor: Praxair Technology, Inc., Danbury, CT 06810-5113 (US)
(72) Inventor: Peck, John D., West Seneca, NY 14224 (US)
(74) Representative: Schwan - Schwan - Schorer

(56) References cited:
- FR-A- 2 532 036
- US-A- 5 465 766
- US-A- 6 077 356
- US-A1- 2002 108 670

## Description

### Field of the Invention

This invention relates to a vapor or liquid phase reagent dispensing apparatus that may be used for dispensing vapor or liquid phase reagents such as precursors for deposition of materials in the manufacture of semiconductor materials and devices.

### Background of the Invention

High purity chemicals used in the semiconductor and pharmaceutical industries require special packaging to maintain their purity in storage. This is especially true for chemicals that react with air and/or moisture in the air. Such high purity chemicals are typically supplied in containers such as bubblers or ampoules.

Modern chemical vapor deposition and atomic layer deposition tools utilize bubblers or ampoules to deliver precursor chemicals to a deposition chamber. These bubblers or ampoules work by passing a carrier gas through a container of high purity liquid precursor chemical and carrying the precursor vapor along with the gas to the deposition chamber.

The containers are typically manufactured as either one-part (i.e., the top cover or lid is not removable from the base) or two-part (i.e., the top cover or lid is removable from the base and can be attached to the base by bolts) containers. The one-part containers have a high degree of integrity, but are more difficult to clean than the two-part containers. Because the top cover or lid can be removed from the base, the two-part containers are easier to clean but are more difficult to seal and reuse. Easier cleaning allows for the reuse of a two-part container beyond what may be achieved with a one-part container. Reuse of containers is important for minimizing costs and also for environmental concerns.

As integrated circuits have decreased in size, so have the dimensions of the internal components or features. As the sizes decreased, the need for more pure chemicals has correspondingly increased to minimize the effect of impurities, Suppliers therefore, must be able to not only manufacture high purity chemicals, but must also be able to deliver them in a container which will maintain the high purity.

The standard materials of construction for these containers shifted from the delicate quartz containers to stainless steel in the late 1990's. See, for example, U.S. Patent No. 5,607,002. These containers are known in the industry either as bubblers or ampoules and are now routinely constructed of stainless steel, e.g., 316SS. See, for example, U.S. Patent Nos. 3,930,591, 6,029,717 and 7,077,388.

Further, in most cases, it is necessary to heat the ampoule by some means in order to increase the vapor pressure of the precursor and thus increase the amount of chemical in the carrier gas. It is important to monitor the temperature of the liquid precursor chemical inside of the ampoule to control the vapor pressure.

It is also important to know when the liquid precursor chemical inside of the ampoule is close to running out so that it can be changed at the end of a chemical vapor deposition or atomic layer deposition cycle. If the ampoule should run dry in the middle of a cycle, the entire batch of wafers will be ruined resulting in a potential loss of millions of dollars. It is therefore desirable to leave as little liquid precursor chemical as possible inside of the ampoule to avoid wasting the valuable liquid precursor chemical. As the cost of chemical precursors increase, wasting as little chemical as possible becomes more important.

For two-part high-purity chemical containers to gain commercial acceptance, it will be necessary to develop a more reliable seal. U.S. Patent No. 6,905,125 relates to a metal gasket such as C-ring gasket to prevent leakage of fluid from semiconductor manufacturing apparatus. High purity chemicals for the electronics industry require leak-tight containers that are able to withstand high vacuum.

It would be desirable in the art to provide an easy to clean, two-part vapor or liquid phase reagent dispensing apparatus which is capable of maintaining high purity of the precursor chemical and also increasing the usage of the precursor chemical in the apparatus, and correspondingly reducing waste thereof.

### Summary of the Invention

This invention relates to a reagent dispensing apparatus as defined in claim 1:

This invention also relates in part to a vapor phase reagent dispensing apparatus comprising:

a vessel which comprises a top wall member, a side wall member and a bottom wall member configured to form an internal vessel compartment to hold a source chemical up to a fill level and to additionally define an inner gas volume above the fill level;

said top wall member having a face seal port opening and optionally one or more other face seal port opening;

a face seal tee fitting having a face seal opening, a carrier gas feed inlet opening and a vapor phase reagent outlet opening;

said face seal port opening having said face seal tee fitting connected thereto through the face seal opening, said face seal port opening and said face seal opening having opposing surfaces, wherein the opposing surfaces are not in contact with one another;

a face seal gasket being aligned and in contact with the opposing surfaces of said face seal port opening and said face seal opening;

fastening means for securing the face seal tee fitting to said face seal port opening through the opposing surfaces and said face seal gasket;

an adapter comprising a metal face seal gasket joined to a tube that extends through the carrier gas feed inlet opening, the face seal opening, the face seal port opening and said inner gas volume into the source chemical and through which a carrier gas can be bubbled into the source chemical to cause at least a portion of source chemical vapor to become entrained in said carrier gas to produce a flow of vapor phase reagent to said inner gas volume above the fill level, said tube having an inlet end adjacent to the carrier gas feed inlet opening and an outlet end adjacent to the bottom wall member;

said carrier gas feed inlet opening having a carrier gas feed inlet fitting attached thereto;

said carrier gas feed inlet opening and said carrier gas feed inlet fitting having opposing surfaces, wherein the opposing surfaces are not in contact with one another;

said metal face seal gasket being aligned and in contact with the opposing surfaces of said carrier gas feed inlet opening and said carrier gas feed inlet fitting;

fastening means for securing the carrier gas feed inlet fitting to said carrier gas feed inlet opening through the opposing surfaces and said metal face seal gasket; and

annular space between the outer wall of said tube and the inner walls of said carrier gas feed inlet opening, said face seal opening and said face seal port opening, through which said vapor phase reagent can be dispensed from said apparatus through said vapor phase reagent outlet opening.

This invention yet further relates in part to a liquid phase reagent dispensing apparatus comprising:

a vessel which comprises a top wall member, a side wall member and a bottom wall member configured to form an internal vessel compartment to hold a source chemical up to a fill level and to additionally define an inner gas volume above the fill level;

said top wall member having a face seal port opening and optionally one or more other face seal port openings;

a face seal tee fitting having a face seal opening, an inert gas feed inlet opening and a liquid phase reagent outlet opening;

said face seal port opening having said face seal tee fitting connected thereto through the face seal opening, said face seal port opening and said face seal opening having opposing surfaces, wherein the opposing surfaces are not in contact with one another;

a face seal gasket being aligned and in contact with the opposing surfaces of said face seal port opening and said face seal opening;

fastening means for securing the face seal tee fitting to said face seal port opening through the opposing surfaces and said face seal gasket;

an adapter comprising a metal face seal gasket joined to a tube that extends through the liquid phase reagent outlet opening, the face seal opening, the face seal port opening and the inner gas volume into the source chemical and through which liquid phase reagent can be dispensed from said apparatus, said tube having an outlet end adjacent to the liquid phase reagent outlet opening and an inlet end adjacent to the bottom wall member;

said liquid phase reagent outlet opening having a liquid phase reagent outlet fitting connected thereto;

said liquid phase reagent outlet opening and said liquid phase reagent outlet fitting having opposing surfaces, wherein the opposing surfaces are not in contact with one another;

said metal face seal gasket being aligned and in contact with the opposing surfaces of said liquid phase reagent outlet opening and said liquid phase reagent outlet fitting;

fastening means for securing the liquid phase reagent outlet fitting to said liquid phase reagent outlet opening through the opposing surfaces and said metal face seal gasket; and

annular space between the outer wall of said tube and the inner walls of said liquid phase reagent outlet opening, said face seal opening and said face seal port opening, through which an inert gas can be fed through the inert gas feed inlet opening into the inner gas volume above the fill level to pressurize the inner gas volume above the fill level.

The vapor phase reagent dispensing apparatus or assembly of the invention may be employed in a wide variety of process systems, including for example chemical vapor deposition systems wherein the vapor phase reagent from the supply vessel is passed to a chemical vapor deposition chamber for deposition of a material layer on a substrate therein from the source vapor.

The vapor or liquid phase reagent dispensing apparatus or assembly of the invention is easy to clean, maintains purity of the liquid precursor chemical, increases usage rate of the liquid or solid precursor chemical and thereby reduces waste.

Other aspects, features and embodiments of the invention will be more fully apparent from the ensuing disclosure and appended claims.

### Brief Description of the Drawings

Fig. 1 is a schematic representation of a vapor phase reagent dispensing apparatus with no dip tube, a vapor phase reagent dispensing apparatus with a bubbler tube, and a liquid phase reagent dispensing apparatus with a dip tube, all shown in partial cross-section.

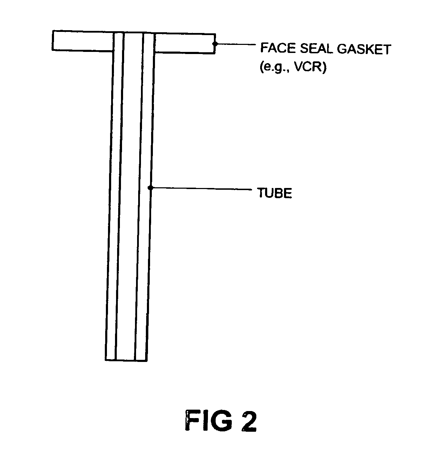

Fig. 2 is a schematic representation of an adapter (i.e., metal face seal gasket and tube) shown in cross-section.

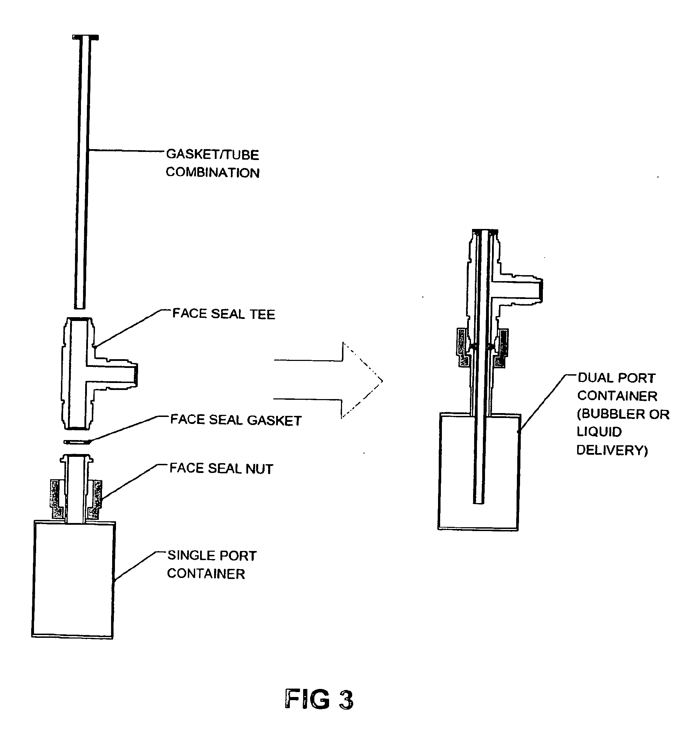

Fig. 3 is a schematic representation of a single port container converted to a dual port container with a tube, shown in cross-section.

Fig. 4 is a schematic representation of components that can be used to assemble a metal face seal gasket connection without an adapter, shown in cross-section.

Fig. 5 is a schematic representation of components that can be used to assemble a metal face seal gasket connection using an adapter, shown in cross-section.

Fig. 6 is a schematic representation of flow paths through a metal face seal gasket connection without an adapter and a metal face seal gasket connection using an adapter, shown in cross-section.

### Detailed Description of the Invention

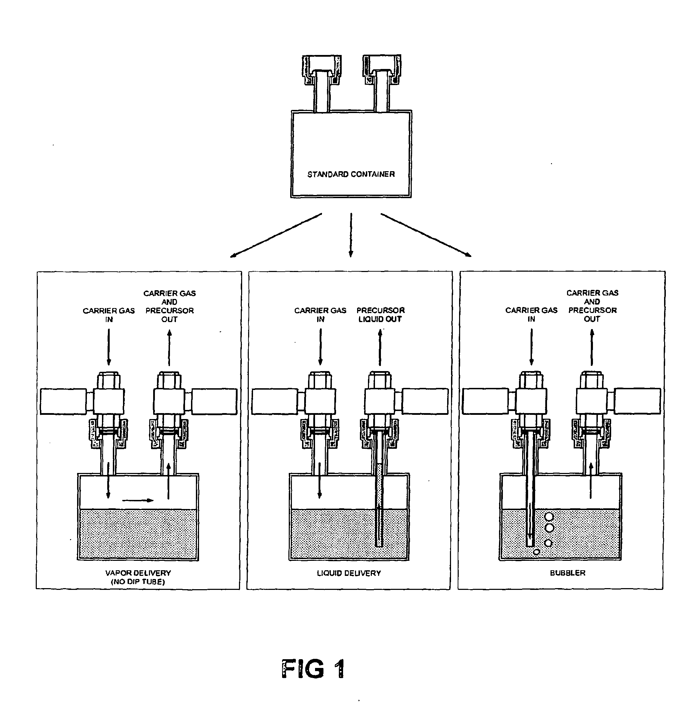

This invention reduces the number of container designs required to support different applications. A standard two port container without a tube can be converted to a container capable of being used in applications which require a tube (i.e., bubbler tube for gas delivery or a dip tube for liquid delivery), by inserting a gasket/tube adapter between one of the ports and the corresponding valve (see Fig. 1). The overall height of the container does not change. In contrast to prior art, the tube is not welded to the top of the container, so it can be removed if modification and/or replacement is necessary. This results in increased flexibility.

The practice of this invention does not increase the length required to add a tube to a container using a face seal port (i.e., the gasket is already being used to seal the connection). Adding a tube to a port that uses a face seal fitting can be accomplished using an adapter with a compression fitting. The tube is inserted through the compression fitting to the desired length and then the compression fitting is secured on the tube. In terms of leak tightness, compression fittings are generally less desirable than joining two components with a face seal (removable) or by welding (not removable). Adding a tube to a port that uses a face seal fitting can be accomplished by using an opposing face seal component that has a tube welded to it, that is the opposite gender (male or female) as the port. From an overhead standpoint, this invention is better than welding a tube to a fitting, because it is universal (i.e., the gasket/tube adapter will work with face seal ports that are either male of female).

This invention simplifies the addition of a tube by allowing the use of standard set of gasket/tube adapters. Modification of the gasket/tube adapter can be done without exposing the container to contamination associated with the modification process (e.g., particles from machining or welding). The length of the tube can easily be changed by cutting it shorter or extending it. The gasket/tube adapter can be leak checked independently from the container. A leak at the seam of a dip tube welded directly to a container will cost more to correct, compared to a gasket/tube adapter (i.e., value of the ampoule is significantly higher than the gasket/tube adapter).

Various modifications and variations of this invention include the use of different materials of construction for the ampoules and adapters (e.g., copper, stainless steel, aluminum, nickel, Teflon, etc.); the use of different methods to join the gasket to the tube in forming the adapter (e.g., welding, machining, shrink fitting, etc.); the use of different face seal gasket styles (e.g., flat or contoured) and manufacturers (e.g., Parker, Hy-Tech, Swagelok, Fujikin, etc.); the use of different size gaskets and tubes (e.g., 3.18 mm (1/8 inch), 6.35 mm (¼ inch), 12.7 mm (¼ inch), *etc.); the length of tube can be varied; the tube can optionally have holes along the length; and the tube may be modified along its length (i.e., non uniform cross-section).

As indicated above and referring to Fig. 1, this invention relates in part to a vapor phase reagent dispensing apparatus comprising:

a vessel which comprises a top wall member, a side wall member and a bottom wall member configured to form an internal vessel compartment to hold a source chemical up to a fill level and to additionally define an inner gas volume above the fill level;

said top wall member having a first face seal port opening, a second face seal port opening and optionally one or more other face seal port openings;

said first face seal port opening having a carrier gas feed inlet fitting connected thereto;

an adapter comprising a metal face seal gasket joined to a tube that extends through the first face seal port opening and said inner gas volume into the source chemical and through which a carrier gas can be bubbled into the source chemical to cause at least a portion of source chemical vapor to become entrained in said carrier gas to produce a flow of vapor phase reagent to said inner gas volume above the fill level, said tube having an inlet end adjacent to the first face seal port opening and an outlet end adjacent to the bottom wall member;

said first face seal port opening and said carrier gas feed inlet fitting having opposing surfaces, wherein the opposing surfaces are not in contact with one another;

said metal face seal gasket being aligned and in contact with the opposing surfaces of said first face seal port opening and said carrier gas feed inlet fitting;

fastening means for securing the carrier gas feed inlet fitting to said first face seal port opening through the opposing surfaces and said metal face seal gasket; and

said second face seal port opening having a vapor phase reagent outlet fitting connected thereto, through which said vapor phase reagent can be dispensed from said apparatus.

The vapor phase reagent dispensing apparatus further comprises a carrier gas feed line extending exteriorly from the carrier gas feed inlet fitting for delivery of carrier gas into said source chemical, the carrier gas feed line containing one or more carrier gas flow control valves therein for control of flow of the carrier gas therethrough; and a vapor phase reagent discharge line extending exteriorly from the vapor phase reagent outlet fitting for removal of vapor phase reagent from said inner gas volume above the fill level, the vapor phase reagent discharge line optionally containing one or more vapor phase reagent flow control valves therein for control of flow of the vapor phase reagent therethrough.

The vapor phase reagent dispensing apparatus further comprises the vapor phase reagent discharge line in vapor phase reagent flow communication with a vapor phase delivery deposition system, said deposition system selected from a chemical vapor deposition system or an atomic layer deposition system.

As indicated above and referring to Fig. 1, this invention also relates in part to a liquid phase reagent dispensing apparatus comprising:

a vessel which comprises a top wall member, a side wall member and a bottom wall member configured to form an internal vessel compartment to hold a source chemical up to a fill level and to additionally define an inner gas volume above the fill level;

said top wall member having a first face seal port opening, a second face seal port opening and optionally one or more other face seal port openings;

said first face seal port opening having an inert gas feed inlet fitting connected thereto, through which an inert gas can be fed into the inner gas volume above the fill level to pressurize the inner gas volume above the fill level;

said second face seal port opening having a liquid phase reagent outlet fitting connected thereto;

an adapter comprising a metal face seal gasket joined to a tube that extends through the second face seal port opening and the inner gas volume into the source chemical and through which liquid phase reagent can be dispensed from said apparatus, said tube having an outlet end adjacent to the second face seal port opening and an inlet end adjacent to the bottom wall member;

said second face seal port opening and said liquid phase reagent outlet fitting having opposing surfaces, wherein the opposing surfaces are not in contact with one another;

said metal face seal gasket being aligned and in contact with the opposing surfaces of said second face seal port opening and said liquid phase reagent outlet fitting; and

fastening means for securing the liquid phase reagent outlet fitting to said second face seal port opening through the opposing surfaces and said metal face seal gasket.

The liquid phase reagent dispensing apparatus further comprises an inert gas feed line extending exteriorly from the inert gas feed inlet fitting for delivery of inert gas into said inner gas volume above the fill level, the inert gas feed line containing one or more inert gas flow control valves therein for control of flow of the inert gas therethrough; and a liquid phase reagent discharge line extending exteriorly from the liquid phase reagent outlet fitting for removal of liquid phase reagent from said vessel, the liquid phase reagent discharge line optionally containing one or more liquid phase reagent flow control valves therein for control of flow of the liquid phase reagent therethrough.

The liquid phase reagent dispensing apparatus further comprises the liquid phase reagent discharge line in liquid phase reagent flow communication with a vaporization apparatus, said vaporization apparatus in vapor phase reagent flow communication with a vapor phase delivery deposition system, said deposition system selected from a chemical vapor deposition system and an atomic layer deposition system.

The vessel or ampoule is typically machined from stainless steel, e.g., 316L, and electropolished to prevent contamination of the precursor liquid or solid source chemical. The adapter is also typically machined from stainless steel. The cover or top wall member is optionally removable to facilitate cleaning and reuse. The vessel can comprise a cylindrically shaped side wall member or side wall members defining a non-cylindrical shape.

Fastening means are used to secure the carrier gas feed inlet fitting to the first face seal port opening through the opposing surfaces and the metal face seal gasket of the adapter. Suitable fastening means include, for example, engagement of a male nut or body hex with a female nut.

Fastening means are used to secure the liquid phase reagent outlet fitting to the second face seal port opening through the opposing surfaces and the metal face seal gasket of the adapter. Suitable fastening means include, for example, engagement of a male nut or body hex with a female nut.

In the practice of this invention, the gasket/tube assembly (i.e., adapter) would affect the flow pattern of fluid through the associated container and/or plumbing. The ability to redirect the flow pattern of a gas or liquid has uses in the delivery of precursors for depositing thin-films. The containers must be fabricated using a material that does not react with the precursor. As indicated above, stainless steel is commonly selected as the material for constructing the precursor container. The gasket tube assembly would be composed of a similar material (e.g., stainless steel or nickel).

This invention can also be utilized to redirect the flow pattern of reactants (vapor phase and/or liquid phase) into a reaction vessel. An example of this utility is the co-injection of reactants used for thin-film deposition. Separation of reactants that are susceptible to vapor-phase reactions, until just prior to contacting the substrate surface, can decrease the likelihood of particle formation and increase film deposition rate.

In the practice of this intention, the gasket/tube adapter would be prefabricated and inserted into the desired port. The face seal connection would then be sealed in the usual manner (e.g., by tightening the connection using the male and female nuts). An example of a face seal connection is VCR components (e.g., Swagelok), but other types could be used.

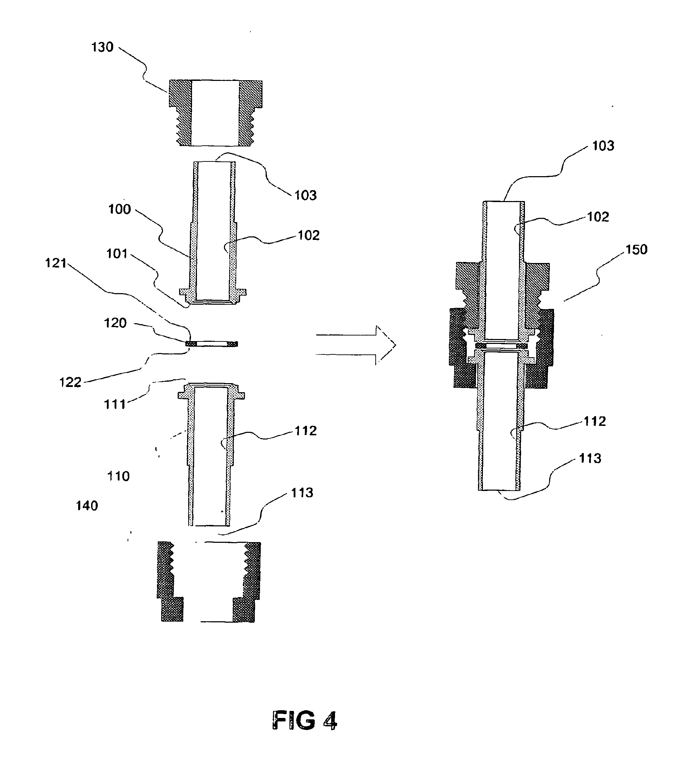

As indicated above, Fig. 4 is a cross-sectional view of components that can be used to assemble a metal gasket face seal connection 150 without a gasket/tube assembly (see Swagelok catalog MS-01-24). Metal gasket 120 is used in sealing face fittings (e.g., VCR from Swagelok). It is a disk with a hole in the center. 121 is the surface of metal gasket 120 that contacts bead 101 of face seal fitting 100 upon sealing. 122 is the surface of metal gasket 120 that contacts bead 111 of face seal fitting 110 upon sealing. 100 is a face seal fitting (e.g., VCR from Swagelok) that uses metal gasket 120 to connect to face seal fitting 110. 101 is the bead that forms the sealing surface of face seal fitting 100 with surface 121 of metal gasket 120. 102 is the internal surface of face seal fitting 100 in contact with the process fluid (liquid or gas). 103 is the end of face seal fitting 100, opposite the sealing bead 101. The end (103) of face seal fitting 100 is joined (e.g., welded) to the other process components (e.g., tubing, valves, vessels, etc.). Depending on the pressure gradient, fluid either enters or exits face seal fitting 100 through end 103.

Face seal fitting 110 uses metal gasket 120 to connect to face seal fitting 100. Bead 111 forms the sealing surface of face seal fitting 110 with surface 122 of metal gasket 120. 112 is the internal surface of face seal fitting 110 in contact with the process fluid (liquid or gas). 113 is the end of face seal fitting 110, opposite the sealing bead 111. The end (113) of face seal fitting 110 is joined (e.g., welded) to the other process components (e.g., tubing, valves, vessels, etc.). Depending on the pressure gradient, fluid either enters or exits face seal fitting 110 through end 113. Male nut 130 is tightened against the female nut 140 to form the assembled connection 150.

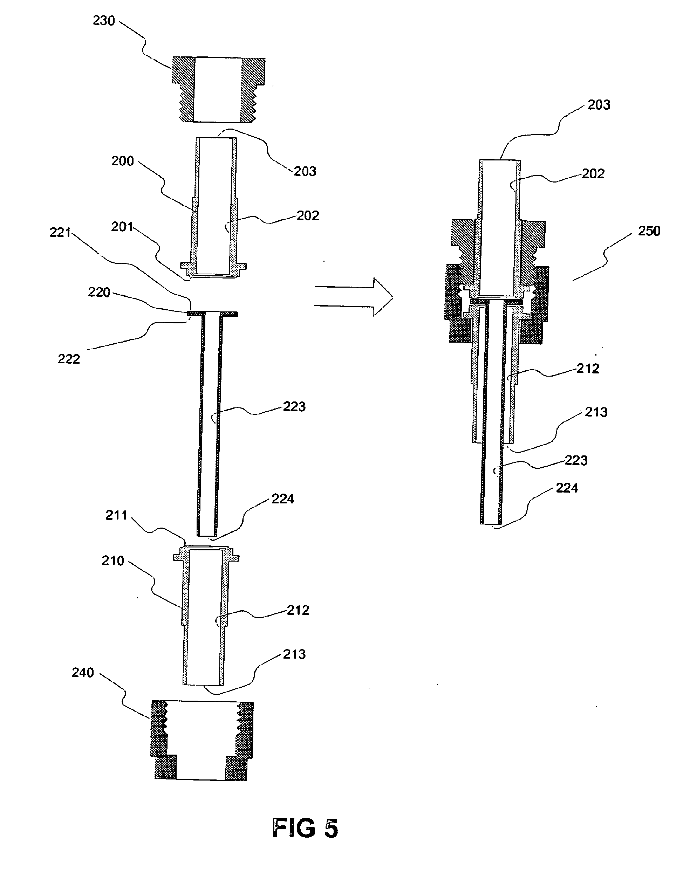

As indicated above, Fig. 5 is a cross-sectional view of components that can be used to assemble a metal gasket face seal connection using a gasket/tube adapter used in this invention. Metal gasket/tube adapter 220 consists of a metal gasket that has been joined to a tube. 221 is the surface of gasket/tube adapter 220 that contacts bead 201 of face seal fitting 200 upon sealing. 222 is the surface of gasket/tube adapter 220 that contacts bead 211 of face seal fitting 210 upon sealing. 223 is the internal surface of gasket/tube adapter 220 in contact with the process fluid (liquid or gas). 224 is the end of the gasket/tube adapter 220, opposite the end where surfaces 221 and 222 contact beads 201 and 211 respectively. Face seal fitting 200 (e.g., VCR from Swagelok) uses metal gasket/tube adapter 220 to connect to face seal fitting 210. Bead 201 forms the sealing surface of face seal fitting 200 with surface 221 of gasket/tube adapter 220. 202 is the internal surface of face seal fitting 200 in contact with the process fluid (liquid or gas).

203 is the end of face seal fitting 200, opposite the sealing bead 201. The end (203) of face seal fitting 200 is joined (e.g., welded) to the other process components (e.g., tubing, valves, vessels, etc.). Depending on the pressure gradient, fluid either enters or exits face seal fitting 200 through end 203.

Face seal fitting 210 uses metal gasket/tube adapter 220 to connect to face seal fitting 200. Bead 211 forms the sealing surface of face seal fitting 210 with surface 222 of gasket/tube adapter 220. 212 is the internal surface of face seal fitting 200 in contact with the process fluid (liquid or gas). 213 is the end of face seal fitting 210, opposite the sealing bead 211. The end (213) of face seal fitting 210 is joined (e.g., welded) to the other process components (e.g., tubing, valves, vessels, etc.). Because the connection was made using gasket/tube adapter 220, fluid does not flow through end 213. Instead, fluid flow proceeds through the end 224 of gasket/tube adapter 220. Male nut 230 is tightened against the female nut 240 to form the assembled connection 250. Upon assembling connection 250, no fluid flow takes place through end 213 of face seal fitting 210. Fluid entering or exiting face seal fitting 200 through end 203 either enters or exits the gasket/tube adapter 220 through end 224.

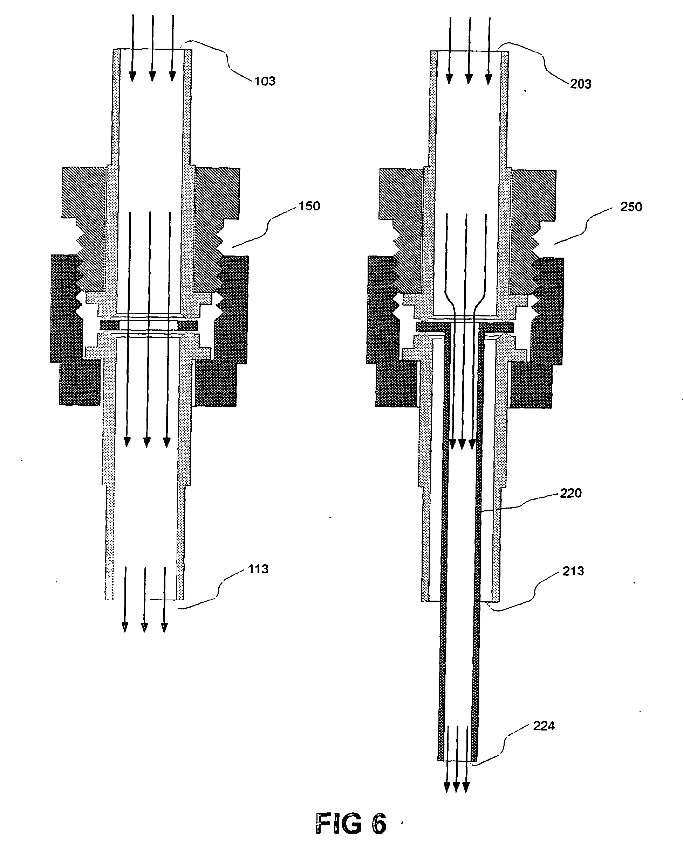

Fig. 6 shows an example of the flow paths through assemblies 150 and 250. The arrows in Fig. 6 indicate the direction and path of fluid flow. Due to the use of the gasket/tube adapter 220 in assembly 250, the path of fluid flow in assembly 250 is different than assembly 150.

The ampoule can include inlet and outlet valves to allow the chemicals to be delivered to the end use equipment. Optional ampoule equipment include a fill port and a source chemical level sensor to determine when the ampoule is nearly empty. The material in the container is delivered either under vacuum, for low vapor pressure chemicals, or using an inert gas to sweep the vapors out. The material may alternatively be delivered as a liquid through a dip tube to the end use equipment where it can be vaporized or dispensed as needled.

A temperature sensor is preferably included in the ampoule to ensure uniform heat conduction. A source chemical level sensor is preferably included in the ampoule to ensure efficient use of the source chemical. The valves and source, chemical level sensor are attached via face seal connections to ensure a clean, leak proof seal. Once assembled in a clean room, the ampoule is conditioned to remove adsorbed water and leak checked with a helium leak detector. The ampoule is designed to be used at pressures from a few torr to slightly above ambient.

In an embodiment of this invention, the temperature sensor extends from an upper end exterior of the vessel through a portion of the top wall member and generally vertically downwardly into the interior volume of the vessel, with the lower end of the temperature sensor being located in non-interfering proximity to the surface of the bottom wall. The source chemical level sensor extends from an upper end exterior of the vessel through a portion of the top wall member and generally vertically downwardly into the interior volume of the vessel, with the lower end of the source chemical level sensor being located in non-interfering proximity to the surface of the bottom wall. The temperature sensor is operatively arranged in the vessel to determine the temperature of source chemical in the vessel, the source chemical level sensor is operatively arranged in the vessel to determine the level of source chemical in the vessel, the temperature sensor and source chemical level sensor are located in non-interfering proximity to each other in the vessel, with the lower end of the temperature sensor being located at the same or closer proximity to the surface of the vessel in relation to the lower end of the source chemical level sensor, and the temperature sensor and source chemical level sensor are in source chemical flow communication in the vessel. The source chemical level sensor is selected from ultrasonic sensors, optical sensors, capacitive sensors and float-type sensors, and said temperature sensor comprises a thermowell and thermocouple.

In an embodiment of this invention, the bottom wall member provides a sump cavity in which the lower end of a temperature sensor, source chemical level sensor, dip tube and/or bubbler tube may be disposed. Such a configuration can permit a high percentage, e.g., 95% or greater, preferably 98% or greater, of the volume of the originally furnished liquid or solid source chemical to be utilized in the application for which the source chemical is selectively dispensed. This configuration can also improve the economics of the source chemical supply and dispensing system and processes in which the dispensed source chemical is employed.

This invention allows for a minimal amount of semiconductor precursor chemical to remain in the ampoule or bubbler when the source chemical level sensor has signaled the end of the contents. This is very important as the complexity and cost of semiconductor precursors rises. In order to minimize costs, semiconductor manufacturers will want to waste as little precursor as possible. In addition, this invention places the temperature sensor in the same recessed sump cavity as the source chemical level sensor. This ensures that the true temperature of the source chemical semiconductor precursor will be read as long as the source chemical level sensor indicates there is precursor present. This is important from a safety standpoint. If the temperature sensor was to be outside of the semiconductor precursor it would send a false low temperature signal to the heating apparatus. This could lead to the application of excessive heat to the ampoule which can cause an unsafe situation and decomposition of the semiconductor precursor.

Referring again to the vessel or ampoule, the vessel can be equipped with a source chemical level sensor which extends from an upper portion exterior of the vessel, downwardly through a non-centrally located portion of the top wall member of the vessel, to a lower end, non-centrally located on the bottom floor member, in close proximity to the surface of the sump cavity of the vessel to permit utilization of at least 95% of source chemical reagent when source chemical reagent is contained in the vessel. The upper portion of the source chemical level sensor may be connected by a source chemical level sensing signal transmission line to a central processing unit, for transmission of sensed source chemical level signals from the source chemical level sensor to the central processing unit during operation of the system.

In a like manner, the vessel can be equipped with a temperature sensor, i.e., a thermowell and thermocouple, which extends from an upper portion exterior of the vessel, downwardly through a centrally located portion of the top wall member of the vessel, to a lower end, centrally located on the bottom wall member, in close proximity to the surface of the sump cavity of the vessel. The upper portion of the temperature sensor may be connected by a temperature sensing signal transmission line to a central processing unit, for transmission of sensed temperature signals from the temperature sensor to the central processing unit during operation of the system.

The central processing unit, which may comprise a suitable microprocessor, computer, or other appropriate control means, may also be joined by a control signal transmission line to a flow control valve (e.g., via a suitable valve actuator element) to selectively adjust flow control valve and control the flow of carrier gas to the vessel. The central processing unit may also be joined by a control signal transmission line to a second flow control valve (e.g., via a suitable valve actuator element) to selectively adjust the flow control valve and control the discharge of vapor or liquid phase reagent from the vessel. For purposes of this invention, flow control valves shall include isolation valves, metering valves and the like.

This invention allows the semiconductor manufacturer to use the maximum amount of precursor while wasting very little before change-out of the ampoule. This minimizes waste and maximizes the return on the investment in the semiconductor precursor and specific application.

The source chemicals useful in this invention can vary over a wide range and include, for example, liquid or solid precursors for a metal selected from Group 2, Group 3, Group 4, Group 5, Group 6, Group 7, Group 8, Group 9, Group 10, Group 11, Group 12, Group 13, Group 14, Group 15, Group 16, and the Lanthanide series of the Periodic Table. Illustrative source chemicals include, for example, liquid or solid precursors for a metal selected from ruthenium, hafnium, tantalum, molybdenum, platinum, gold, titanium, lead, palladium, zirconium, bismuth, strontium, barium, calcium, antimony and thallium, or precursor for a metalloid selected from silicon, germanium and tellurium. Preferred organometallic precursor compounds include ruthenium-containing, hafnium-containing, tantalum-containing and/or molybdenum-containing organometallic precursor compounds.

Solid source chemicals that sublime and solid source chemicals that melt upon heating can be used in this invention. For example, solid source chemicals that sublime can be used in the vapor phase reagent dispensing apparatus shown in Fig. 1. Solid source chemicals that melt upon heating can be used in the vapor phase reagent dispensing apparatus shown in Fig. 1 and the liquid phase reagent dispensing apparatus shown in Fig. 1. Likewise, liquid source chemicals can be used in the vapor phase reagent dispensing apparatus shown in Fig. 1 and the liquid phase reagent dispensing apparatus shown in Fig. 1. When using solid source chemicals that sublime, it may be necessary to employ dust entrapment equipment.

The vapor or liquid phase reagents useful in this invention can vary over a wide range and include, for example, liquid or solid precursors for a metal selected from Group 2, Group 3, Group 4, Group 5, Group 6, Group 7, Group 8, Group 9, Group 10, Group 11, Group 12, Group 13, Group 14, Group 15, Group 16, and the Lanthanide series of the Periodic Table. Illustrative precursors include, for example, precursors for a metal selected from ruthenium, hafnium, tantalum, molybdenum, platinum, gold, titanium, lead, palladium, zirconium, bismuth, strontium, barium, calcium, antimony and thallium, or precursor for a metalloid selected from silicon, germanium and tellurium. Preferred organometallic precursor compounds include ruthenium-containing, hafnium-containing, tantalum-containing and/or molybdenum-containing organometallic precursor compounds.

The vapor phase reagent dispensing apparatus can further comprise a carrier gas source coupled to the carrier gas feed line. Likewise, the liquid phase reagent dispensing apparatus can further comprise an inert gas source coupled to the inert gas feed line.

The vapor phase reagent dispensing apparatus can further comprise:

a deposition chamber selected from a chemical vapor deposition chamber or an atomic layer deposition chamber;

the vapor phase reagent discharge line connecting the vapor phase reagent dispensing apparatus to the deposition chamber;

optionally a heatable susceptor contained within the deposition chamber and located in a receiving relationship to the vapor phase reagent discharge line; and

an effluent discharge line connected to the deposition chamber;

such that vapor phase reagent passes through the vapor phase reagent discharge line and into the deposition chamber, for contact with a substrate, optionally on the heatable susceptor, and any remaining effluent is discharged through the effluent discharge line.

The substrate is comprised of a material selected from a metal, a metal silicide, a metal carbide, a metal nitride, a semiconductor, an insulator and a barrier material. The substrate is preferably a patterned wafer.

The liquid phase reagent dispensing apparatus can further comprise:

a deposition chamber selected from a chemical vapor deposition chamber and an atomic layer deposition chamber;

the liquid phase reagent discharge line connecting the liquid phase reagent dispensing apparatus to a vaporization apparatus;

a portion of the vaporization apparatus having a carrier gas feed inlet opening through which carrier gas can be fed into said vaporization apparatus to cause vapor of said liquid phase reagent to become entrained in said carrier gas to produce vapor phase reagent;

a portion of the vaporization apparatus having a vapor phase reagent outlet opening through which said vapor phase reagent can be dispensed from said vaporization apparatus;

a carrier gas feed line extending from the carrier gas feed inlet opening exteriorly from the vaporization apparatus for delivery of carrier gas into said vaporization apparatus, the carrier gas feed line containing a carrier gas flow control valve therein for control of flow of the carrier gas therethrough;

a vapor phase reagent discharge line extending from the vapor phase reagent outlet opening exteriorly from the vaporization apparatus for removal of vapor phase reagent from said vaporization apparatus to said deposition chamber, the vapor phase reagent discharge line containing a vapor phase reagent flow control valve therein for control of flow of the vapor phase reagent therethrough;

optionally a heatable susceptor contained within the deposition chamber and located in a receiving relationship to the vaporization apparatus; and

an effluent discharge line connected to the deposition chamber;

such that vapor phase reagent passes through the vapor phase reagent discharge line and into the deposition chamber, for contact with a substrate, optionally on the heatable susceptor, and any retaining effluent is discharged through the effluent discharge line.

The substrate can be comprised of a material selected from a metal, a metal silicide, a metal carbide, a metal nitride, a semiconductor, an insulator and a barrier material. The substrate is preferably a patterned wafer.

In another embodiment, this invention also relates in part to a vapor phase reagent dispensing apparatus comprising:

a vessel which comprises a top wall member, a side wall member and a bottom wall member configured to form an internal vessel compartment to hold a source chemical up to a fill level and to additionally define an inner gas volume above the fill level;

said top wall member having a face seal port opening and optionally one or more other face seal port openings;

a face seal tee fitting having a face seal opening, a carrier gas feed inlet opening and a vapor phase reagent outlet opening;

said face seal port opening having said face seal tee fitting connected thereto through the face seal opening, said face seal port opening and said face seal opening having opposing surfaces, wherein the opposing surfaces are not in contact with one another;

a face seal gasket, e.g., metal, being aligned and in contact with the opposing surfaces of said face seal port opening and said face seal opening;

fastening means for securing the face seal tee fitting to said face seal port opening through the opposing surfaces and said face seal gasket;

an adapter comprising a metal face seal gasket joined to a tube that extends through the carrier gas feed inlet opening, the face seal opening, the face seal port opening and said inner gas volume into the source chemical and through which a carrier gas can be bubbled into the source chemical to cause at least a portion of source chemical vapor to become entrained in said carrier gas to produce a flow of vapor phase reagent to said inner gas volume above the fill level, said tube having an inlet end adjacent to the carrier gas feed inlet opening and an outlet end adjacent to the bottom wall member;

said carrier gas feed inlet opening having a carrier gas feed inlet fitting attached thereto;

said carrier gas feed inlet opening and said carrier gas feed inlet fitting having opposing surfaces, wherein the opposing surfaces are not in contact with one another;

said metal face seal gasket being aligned and in contact with the opposing surfaces of said carrier gas feed inlet opening and said carrier gas feed inlet fitting;

fastening means for securing the carrier gas feed inlet fitting to said carrier gas feed inlet opening through the opposing surfaces and said metal face seal gasket; and

annular space between the outer wall of said tube and the inner walls of said carrier gas feed inlet opening, said face seal opening and said face seal port opening, through which said vapor phase reagent can be dispensed from said apparatus through said vapor phase reagent outlet opening.

The vapor phase reagent dispensing apparatus further comprises a carrier gas feed line extending exteriorly from the carrier gas feed inlet fitting for delivery of carrier gas into said source chemical, the carrier gas feed line containing one or more carrier gas flow control valves therein for control of flow of the carrier gas therethrough; and a vapor phase reagent discharge line extending exteriorly from the vapor phase reagent outlet opening for removal of vapor phase reagent from said inner gas volume above the fill level, the vapor phase reagent discharge line optionally containing one or more vapor phase reagent flow control valves therein for control of flow of the vapor phase reagent therethrough.

The vapor phase reagent dispensing apparatus further comprises the vapor phase reagent discharge line in vapor phase reagent flow communication with a vapor phase delivery deposition system, said deposition system selected from a chemical vapor deposition system or an atomic layer deposition system.

The vapor phase reagent dispensing apparatus further comprises:

a deposition chamber selected from a chemical vapor deposition chamber or an atomic layer deposition chamber;

the vapor phase reagent discharge line connecting the vapor phase reagent dispensing apparatus to the deposition chamber;

optionally a heatable susceptor contained within the deposition chamber and located in a receiving relationship to the vapor phase reagent discharge line; and

an effluent discharge line connected to the deposition chamber;

such that vapor phase reagent passes through the vapor phase reagent discharge line and into the deposition chamber, for contact with a substrate, optionally on the heatable susceptor, and any remaining effluent is discharged through the effluent discharge line.

The substrate is comprised of a material selected from a metal, a metal silicide, a metal carbide, a metal nitride, a semiconductor, an insulator and a barrier material. The substrate is preferably a patterned wafer.

In another embodiment, this invention relates in part to a liquid phase reagent dispensing apparatus comprising:

a vessel which comprises a top wall member, a side wall member and a bottom wall member configured to form an internal vessel compartment to hold a source chemical up to a fill level and to additionally define an inner gas volume above the fill level;

said top wall member having a face seal port opening and optionally one or more other face seal port opening;

a face seal tee fitting having a face seal opening, an inert gas feed inlet opening and a liquid phase reagent outlet opening;

said face seal port opening having said face seal tee fitting connected thereto through the face seal opening, said face seal port opening and said face seal opening having opposing surfaces, wherein the opposing surfaces are not in contact with one another;

a face seal gasket, e.g., metal, being aligned and in contact with the opposing surfaces of said face seal port opening and said face seal opening;

fastening means for securing the face seal tee fitting to said face seal port opening through the opposing surfaces and said face seal gasket;

an adapter comprising a metal face seal gasket joined to a tube that extends through the liquid phase reagent outlet opening, the face seal opening, the face seal port opening and the inner gas volume into the source chemical and through which liquid phase reagent can be dispensed from said apparatus, said tube having an outlet end adjacent to the liquid phase reagent outlet opening and an inlet end adjacent to the bottom wall member;

said liquid phase reagent outlet opening having a liquid phase reagent outlet fitting connected thereto;

said liquid phase reagent outlet opening and said liquid phase reagent outlet fitting having opposing surfaces, wherein the opposing surfaces are not in contact with one another;

said metal face seal gasket being aligned and in contact with the opposing surfaces of said liquid phase reagent outlet opening and said liquid phase reagent outlet fitting;

fastening means for securing the liquid phase reagent outlet fitting to said liquid phase reagent outlet opening through the opposing surfaces and said metal face seal gasket; and

annular space between the outer wall of said tube and the inner walls of said liquid phase reagent outlet opening, said face seal opening and said face seal port opening, through which an inert gas can be fed through the inert gas feed inlet opening into the inner gas volume above the fill level to pressurize the inner gas volume above the fill level.

The liquid phase reagent dispensing apparatus further comprises an inert gas feed line extending exteriorly from the inert gas feed inlet opening for delivery of inert gas into said inner gas volume above the fill level, the inert gas feed line containing one or more inert gas flow control valves therein for control of flow of the inert gas therethrough; and a liquid phase reagent discharge line extending exteriorly from the liquid phase reagent outlet fitting for removal of liquid phase reagent from said vessel, the liquid phase reagent discharge line optionally containing one or more liquid phase reagent flow control valves therein for control of flow of the liquid phase reagent therethrough.

The liquid phase reagent dispensing apparatus further comprises the liquid phase reagent discharge line in liquid phase reagent flow communication with a vaporization apparatus, said vaporization apparatus in vapor phase reagent flow communication with a vapor phase delivery deposition system, said deposition system selected from a chemical vapor deposition system and an atomic layer deposition system.

The liquid phase reagent dispensing apparatus further comprises:

a deposition chamber selected from a chemical vapor deposition chamber and an atomic layer deposition chamber;

the liquid phase reagent discharge line connecting the liquid phase reagent dispensing apparatus to a vaporization apparatus;

a portion of the vaporization apparatus having a carrier gas feed inlet opening through which carrier gas can be fed into said vaporization apparatus to cause vapor of said liquid phase reagent to become entrained in said carrier gas to produce vapor phase reagent;

a portion of the vaporization apparatus having a vapor phase reagent outlet opening through which said vapor phase reagent can be dispensed from said vaporization apparatus;

a carrier gas feed line extending from the carrier gas feed inlet opening exteriorly from the vaporization apparatus for delivery of carrier gas into said vaporization apparatus, the carrier gas feed line containing a carrier gas flow control valve therein for control of flow of the carrier gas therethrough;

a vapor phase reagent discharge line extending from the vapor phase reagent outlet opening exteriorly from the vaporization apparatus for removal of vapor phase reagent from said vaporization apparatus to said deposition chamber, the vapor phase reagent discharge line containing a vapor phase reagent flow control valve therein for control of flow of the vapor phase reagent therethrough;

a heatable susceptor contained within the deposition chamber and located in a receiving relationship to the vaporization apparatus; and

an effluent discharge line connected to the deposition chamber;

such that vapor phase reagent passes through the vapor phase reagent discharge line and into the deposition chamber, for contact with a substrate on the heatable susceptor and any remaining effluent is discharged through the effluent discharge line.

The substrate is comprised of a material selected from a metal, a metal silicide, a metal carbide, a metal nitride, a semiconductor, an insulator and a barrier material. The substrate is preferably a patterned wafer.

In operation of the system described above, source chemical is placed in the vessel and heated to a temperature sufficient to vaporize the source chemical. Carrier gas is allowed to flow through the carrier gas feed line to the carrier gas feed inlet opening and through bubbler tube from which it is bubbled into the source chemical. A carrier gas flow control valve controls the flow of the carrier gas that is discharged into the source chemical. Vapor from the source chemical becomes entrained in the carrier gas to produce vapor phase reagent.

The vapor phase reagent is discharged from the inner gas volume through the vapor phase reagent outlet opening and the vapor phase reagent discharge line. The vapor phase reagent is flowed in the vapor phase reagent discharge line to the deposition chamber. A vapor phase reagent flow control valve controls the flow of the vapor phase reagent that is flowed to the deposition chamber. In the deposition chamber, the vapor phase reagent is deposited onto the wafer or other substrate element that is mounted on a heatable substrate or other mount structure. Effluent vapor from the deposition chamber is discharged in effluent discharge line. The effluent may be passed to recycle, recovery, waste treatment, disposal, or other disposition means.

During this operation, the source chemical fill level in the vessel is detected by a source chemical level sensor. It is important to know when the liquid precursor chemical inside of the vessel is close to running out so that it can be changed at the end of a chemical vapor deposition or atomic layer deposition cycle. The source chemical level progressively declines and eventually lowers into the sump cavity to a minimum liquid head (height of liquid in the sump cavity), at which point the central processing unit receives a corresponding sensed source chemical level signal by a source chemical level sensing signal transmission line. The central processing unit responsively transmits a control signal in a control signal transmission line to the carrier gas flow control valve to close the valve and shut off the flow of carrier gas to the vessel, and also concurrently transmits a control signal in a control signal transmission line to close the vapor phase reagent flow control valve, to shut off the flow of vapor phase reagent from the vessel.

Also, during this operation, the temperature of the source chemical in vessel is detected by a temperature sensor. It is important to monitor the temperature of the liquid precursor chemical inside of the vessel to control the vapor pressure. If the temperature of the source chemical in the vessel becomes too high, the central processing unit receives a corresponding sensed temperature signal by a temperature sensing signal transmission line. The central processing unit responsively transmits a control signal in a control signal transmission line to a heating means to decrease the temperature.

The vapor phase reagent dispensing apparatus, e.g., bubbler, of this invention may be useful for vaporization of liquids and solid materials, e.g., liquid and solid source reagents used in chemical vapor deposition, atomic layer deposition and ion implantation processes. See, for example, U.S. Patent 7,077,388 B2.

In operation of the system described above, source chemical is placed in the vessel and an inert gas is allowed to flow through the inert gas feed line to the inert gas feed inlet opening and into the inner gas volume above the fill level to pressurize the inner gas volume above the fill level. An inert gas flow control valve controls the flow of the inert gas that is discharged into the inner gas volume above the fill level.

The liquid phase reagent is discharged from the vessel through liquid phase reagent outlet opening (e.g., dip tube) and the liquid phase reagent discharge line. The liquid phase reagent is flowed in the liquid phase reagent discharge line to the vaporization apparatus. A liquid phase reagent flow control valve controls the flow of the liquid phase reagent that is flowed to the vaporization apparatus.

In vaporization apparatus, the liquid phase reagent is vaporized to form a source vapor for the subsequent vapor deposition operation. The vaporization apparatus may also receive a carrier gas for combining with or shrouding the source vapor produced by vaporization of the liquid phase reagent. Alternatively, the source vapor may be passed to the downstream vapor deposition operation in neat form. In any event, the source vapor from vaporization apparatus is flowed through vapor phase reagent discharge line to deposition chamber. In the deposition chamber, the vapor phase reagent is deposited onto the wafer or other substrate element that is mounted on a heatable substrate or other mount structure. Effluent vapor from the deposition chamber is discharged in effluent discharge line. The effluent may be passed to recycle, recovery, waste treatment, disposal, or other disposition means.

During this operation, the source chemical fill level in the vessel is detected by a source chemical level sensor. It is important to know when the liquid precursor chemical inside of the vessel is close to running out so that it can be changed at the end of a chemical vapor deposition or atomic layer deposition cycle. The source chemical level progressively declines and eventually lowers into the sump cavity to a minimum liquid head (height of liquid in the sump cavity), at which point the central processing unit receives a corresponding sensed source chemical level signal by a source chemical level sensing signal transmission line. The central processing unit responsively transmits a control signal in a control signal transmission line to the carrier gas flow control valve to close the valve and shut off the flow of carrier gas to the vessel, and also concurrently transmits a control signal in a control signal transmission line to close the liquid phase reagent flow control valve, to shut off the flow of liquid reagent from the vessel.

Also, during this operation, the temperature of the source chemical in vessel is detected by a temperature sensor. It is important to monitor the temperature of the liquid precursor chemical inside of the vessel to control the vapor pressure. If the temperature of the source chemical in the vessel becomes too high, the central processing unit receives a corresponding sensed temperature signal by a temperature sensing signal transmission line. The central processing unit responsively transmits a control signal in a control signal transmission line to a heating means to decrease the temperature.

The liquid phase reagent dispensing apparatus of this invention may be useful for dispensing of reagents such as precursors used in chemical vapor deposition, atomic layer deposition and ion implantation processes, and can achieve a high level of withdrawal of liquid reagent from the vessel. See, for example, U.S. Patent 6,077,356.

Deposition methods described herein can be conducted to form a film, powder or coating that includes a single metal or a film, powder or coating that includes a single metal oxide. Mixed films, powders or coatings also can be deposited, for instance mixed metal oxide films. A mixed metal oxide film can be formed, for example, by employing several organometallic precursors, at least one of which being selected from the organometallic compounds described above.

Vapor phase film deposition can be conducted to form film layers of a desired thickness, for example, in the range of from less than 1 nm to over 1 mm. The precursors described herein are particularly useful for producing thin films, e.g., films having a thickness in the range of from about 10 nm to about 100 nm. Films of this invention, for instance, can be considered for fabricating metal electrodes, in particular as n-channel metal electrodes in logic, as capacitor electrodes for DRAM applications, and as dielectric materials.

The deposition method also is suited for preparing layered films, wherein at least two of the layers differ in phase or composition. Examples of layered film include metal-insulator-semiconductor, and metal-insulator-metal.

The organometallic compound precursors can be employed in atomic layer deposition, chemical vapor deposition or, more specifically, in metalorganic chemical vapor deposition processes known in the art. For instance, the organometallic compound precursors described above can be used in atmospheric, as well as in low pressure, chemical vapor deposition processes. The compounds can be employed in hot wall chemical vapor deposition, a method in which the entire reaction chamber is heated, as well as in cold or warm wall type chemical vapor deposition, a technique in which only the substrate is being heated.

The organometallic compound precursors described above also can be used in plasma or photo-assisted chemical vapor deposition processes, in which the energy from a plasma or electromagnetic energy, respectively, is used to activate the chemical vapor deposition precursor. The compounds also can be employed in ion-beam, electron-beam assisted chemical vapor deposition processes in which, respectively, an ion beam or electron beam is directed to the substrate to supply energy for decomposing a chemical vapor deposition precursor. Laser-assisted chemical vapor deposition processes, in which laser light is directed to the substrate to affect photolytic reactions of the chemical vapor deposition precursor, also can be used.

The deposition method can be conducted in various chemical vapor deposition reactors, such as, for instance, hot or cold-wall reactors, plasma-assisted, beam-assisted or laser-assisted reactors, as known in the art.

Illustrative substrates useful in the deposition chamber include, for example, materials selected from a metal, a metal silicide, a semiconductor, an insulator and a barrier material. A preferred substrate is a patterned wafer. Examples of substrates that can be coated employing the deposition method include solid substrates such as metal substrates, e.g., Al, Ni, Ti, Co, Pt, Ta; metal silicides, e.g., TiSi₂, CoSi₂, NiSi₂; semiconductor materials, e.g., Si, SiGe, GaAs, InP, diamond, GaN, SiC; insulators, e.g., SiO₂, Si₃N₄, HfO₂, Ta₂O₅, Al₂O₃, barium strontium titanate (BST); barrier materials, e.g., TiN, TaN; or on substrates that include combinations of materials. In addition, films or coatings can be formed on glass, ceramics, plastics, thermoset polymeric materials, and on other coatings or film layers. In a preferred embodiment, film deposition is on a substrate used in the manufacture or processing of electronic components. In other embodiments, a substrate is employed to support a low resistivity conductor deposit that is stable in the presence of an oxidizer at high temperature or an optically transmitting film.

The deposition method can be conducted to deposit a film on a substrate that has a smooth, flat surface. In an embodiment, the method is conducted to deposit a film on a substrate used in wafer manufacturing or processing. For instance, the method can be conducted to deposit a film on patterned substrates that include features such as trenches, holes or vias. Furthermore, the deposition method also can be integrated with other steps in wafer manufacturing or processing, e.g., masking, etching and others.

Chemical vapor deposition films can be deposited to a desired thickness. For example, films formed can be less than 1 micron thick, preferably less than 500 nanometers and more preferably less than 200 nanometers thick. Films that are less than 50 nanometers thick, for instance, films that have a thickness between about 0.1 and about 20 nanometers, also can be produced.

Organometallic compound precursors described above also can be employed in the method of the invention to form films by atomic layer deposition or atomic layer nucleation techniques, during which a substrate is exposed to alternate pulses of precursor, oxidizer and inert gas streams. Sequential layer deposition techniques are described, for example, in U.S. Patent No. 6,287,965 and in U.S. Patent No. 6,342,277. The disclosures of both patents are incorporated herein by reference in their entirety.

For example, in one atomic layer deposition cycle, a substrate is exposed, in step-wise manner, to: a) an inert gas; b) inert gas carrying precursor vapor; c) inert gas; and d) oxidizer, alone or together with inert gas. In general, each step can be as short as the equipment will permit (e.g. milliseconds) and as long as the process requires (e.g. several seconds or minutes). The duration of one cycle can be as short as milliseconds and as long as minutes. The cycle is repeated over a period that can range from a few minutes to hours. Film produced can be a few nanometers thin or thicker, e.g., 1 millimeter (mm).

The means of this invention thus achieves a substantial advance in the art, in the provision of a system for supply and dispensing of a vapor or liquid phase reagent, which permits 95-98% of the volume of the originally furnished source chemical to be utilized in the application for which the vapor or liquid phase reagent is selectively dispensed. The ease of cleaning of the two-part ampoule allows for re-use of these ampoules beyond what may be attained with the one-part ampoules.

Correspondingly, in operations such as the manufacture of semiconductor and superconductor products, it is possible with the means and method of this invention to reduce the waste of the source chemical to levels as low as 2-5% of the volume originally loaded into the dispensing vessel, and to re-use the ampoules many times over.

Accordingly, the practice of this invention markedly improves the economics of the source chemical supply and vapor or liquid phase reagent dispensing system. The invention in some instances may permit the cost-effective utilization of source chemicals which were as a practical matter precluded by the waste levels characteristic of prior art practice.

## Claims

1. A reagent dispensing apparatus comprising:
a vessel which comprises a top wall member, a side wall member and a bottom wall member configured to form an internal vessel compartment to hold a source chemical up to a fill level and to additionally define an inner gas volume above the fill level;
said top wall member having a first face seal port opening (210), a second face seal port opening (110) and optionally one or more other face seal port openings;
said first face seal port opening having a first fitting (200) connected thereto and serving as a carrier gas feed inlet fitting or as a liquid phase reagent outlet fitting;
an adapter (220) comprising a metal face seal gasket joined to a tube that extends through the first face seal port opening and said inner gas volume into the source chemical and through which a carrier gas can be bubbled into the source chemical to cause at least a portion of source chemical vapor to become entrained in said carrier gas to produce a flow of vapor phase reagent to said inner gas volume above the fill level or a liquid phase reagent can be dispensed from the apparatus, said tube having a first end (221) adjacent to the first face seal port opening and a second end (224) adjacent to the bottom wall member;
said first face seal port opening and said first fitting having opposing surfaces;
fastening means (230, 240) for securing the first fitting to said first face seal port opening through the opposing surfaces and said metal face seal gasket; and
said second face seal port opening having second fitting (100) connected thereto which is a vapor phase reagent outlet fitting, through which said vapor phase reagent can be dispensed from said apparatus, or which is, in case that the first fitting serves as a liquid phase reagent outlet fitting, a carrier gas feed inlet fitting through which a carrier gas can be fed into the inner gas volume above the fill level to pressurize the inner gas volume above the fill level, **characterised in that**
said opposing surfaces of the first face seal port opening and said first fitting are not in contact with one another, and said metal face seal gasket is aligned and in contact with said opposing surfaces of said first face seal port opening and said first fitting.

2. The dispensing apparatus of claim 1 wherein the tube (220) comprises a bubbler tube and is made of stainless steel.

3. The dispensing apparatus of claim 1 further comprising:
a carrier gas feed line extending exteriorly from the first fitting (200) for delivery of carrier gas into said source chemical, the carrier gas feed line containing one or more carrier gas flow control valves therein for control of flow of the carrier gas therethrough; and
a vapor phase reagent discharge line extending exteriorly from the second fitting (100) for removal of vapor phase reagent from said inner gas volume above the fill level, the vapor phase reagent discharge line optionally containing one or more vapor phase reagent flow control valves therein for control of flow of the vapor phase reagent therethrough.

4. The dispensing apparatus of claim 3 further comprising the vapor phase reagent discharge line in vapor phase reagent flow communication with a vapor phase delivery deposition system, said deposition system selected from a chemical vapor deposition system or an atomic layer deposition system.

5. The dispensing apparatus of claim 3 further comprising a carrier gas source coupled to the carrier gas feed line.

6. The dispensing apparatus of claim 3 further comprising:
a deposition chamber selected from a chemical vapor deposition chamber or an atomic layer deposition chamber;
the vapor phase reagent discharge line connecting the dispensing apparatus to the deposition chamber;
optionally a heatable susceptor contained within the deposition chamber and located in a receiving relationship to the vapor phase reagent discharge line; and
an effluent discharge line connected to the deposition chamber;
such that vapor phase reagent passes through the vapor phase reagent discharge line and into the deposition chamber, for contact with a substrate, optionally on the heatable susceptor, and any remaining effluent is discharged through the effluent discharge line.

7. The dispensing apparatus of claim 1 wherein the vessel is made of stainless steel.

8. The dispensing apparatus of claim 1 wherein the tube comprises a dip tube and is made of stainless steel.

9. The dispensing apparatus of claim 1 wherein the fastening means comprise engagement of a male nut (230) or body hex with a female nut (240).

10. The dispensing apparatus of claim 1 further comprising:
an inert carrier gas feed line extending exteriorly from the first fitting for delivery of inert carrier gas into said inner gas volume above the fill level, the inert carrier gas feed line containing one or more inert carrier gas flow control valves therein for control of flow of the inert carrier gas therethrough; and
a liquid phase reagent discharge line extending exteriorly from the second fitting for removal of liquid phase reagent from said vessel, the liquid phase reagent discharge line optionally containing one or more liquid phase reagent flow control valves therein for control of flow of the liquid phase reagent therethrough.

11. The dispensing apparatus of claim 1 in which said bottom wall member has a sump cavity therein extending downwardly from the surface of said bottom wall member.

12. The dispensing apparatus of claim 11 further comprising:
a temperature sensor extending from said top wall member generally vertically downwardly through the inner gas volume into the source chemical, with the lower end of the temperature sensor being located in non-interfering proximity to the surface of the sump cavity;
a source chemical level sensor extending from a third face seal port opening on said top wall member generally vertically downwardly through the inner gas volume into the source chemical, with the lower end of the source chemical level sensor being located in non-interfering proximity to the surface of the sump cavity; and
the temperature sensor being operatively arranged in the vessel to determine the temperature of source chemical in the vessel, the source chemical level sensor being operatively arranged in the vessel to determine the level of source chemical in the vessel, the temperature sensor and source chemical level sensor being located in non-interfering proximity to each other in the vessel, with the lower end of the temperature sensor being located at the same or closer proximity to the surface of the sump cavity in relation to the lower end of the source chemical level sensor, and the temperature sensor and source chemical level sensor being in source chemical flow communication in the vessel.

13. The dispensing apparatus of claim 10 further comprising the liquid phase reagent discharge line in liquid phase reagent flow communication with a vaporization apparatus, said vaporization apparatus in vapor phase reagent flow communication with a vapor phase delivery deposition system, said deposition system selected from a chemical vapor deposition system and an atomic layer deposition system.

14. The dispensing apparatus of claim 1 wherein the vessel comprises a cylindrically shaped side wall member or side wall members defining a non-cylindrical shape.

15. The dispensing apparatus of claim 1 wherein the source chemical comprises a liquid or solid material.

16. The dispensing apparatus of claim 1 wherein the source chemical comprises a liquid or solid precursor for a metal selected from Group 2, Group 3, Group 4, Group 5, Group 6, Group 7, Group 8, Group 9, Group 10, Group 11, Group 12, Group 13, Group 14, Group 15, Group 16, and the Lanthanide series of the Periodic Table.

17. The dispensing apparatus of claim 1 wherein the source chemical comprises a precursor for a metal selected from ruthenium, hafnium tantalum, molybdenum, platinum, gold, titanium, lead, palladium, zirconium, bismuth, strontium, barium, calcium, antimony and thallium, or a precursor for a metalloid selected from silicon, germanium and tellurium.

18. The dispensing apparatus of claim 1 wherein the vapor phase reagent comprises a vapor phase precursor for a metal selected from Group 2, Group 3, Group 4, Group 5, Group 6, Group 7, Group 8, Group 9, Group 10, Group 11, Group 12, Group 13, Group 14, Group 15, Group 16, and the Lanthanide series of the Periodic Table.

19. The dispensing apparatus of claim 1, wherein the vapor phase reagent comprises a precursor for a metal selected from ruthenium, hafnium, tantalum, molybdenum, platinum, gold, titanium, lead, palladium, zirconium, bismuth, strontium, barium, calcium, antimony and thallium, or a precursor for a metalloid selected from silicon, germanium and tellurium.

20. The dispensing apparatus of claim 1 further comprising an inert gas source coupled to the first fitting (200).

21. The dispensing apparatus of claim 1 further comprising:
a deposition chamber selected from a chemical vapor deposition chamber and an atonic layer deposition chamber;
a liquid phase reagent discharge line connecting the reagent dispensing apparatus to a vaporization apparatus;
a portion of the vaporization apparatus having a carrier gas feed inlet opening through which carrier gas can be fed into said vaporization apparatus to cause vapor of said liquid phase reagent to become entrained in said carrier gas to produce vapor phase reagent;
a portion of the vaporization apparatus having a vapor phase reagent outlet opening through which said vapor phase reagent can be dispensed from said vaporization apparatus;
a carrier gas feed line extending from the carrier gas feed inlet opening exteriorly from the vaporization apparatus for delivery of carrier gas into said vaporization apparatus, the carrier gas feed line containing a carrier gas flow control valve therein for control of flow of the carrier gas therethrough;
a vapor phase reagent discharge line extending from the vapor phase reagent outlet opening exteriorly from the vaporization apparatus for removal of vapor phase reagent from said vaporization apparatus to said deposition chamber, the vapor phase reagent discharge line containing a vapor phase reagent flow control valve therein for control of flow of the vapor phase reagent therethrough;
optionally a heatable susceptor contained within the deposition chamber and located in a receiving relationship to the vaporization apparatus; and
an effluent discharge line connected to the deposition chamber;
such that vapor phase reagent passes through the vapor phase reagent discharge line and into the deposition chamber, for contact with a substrate, optionally on the heatable susceptor, and any remaining effluent is discharged through the effluent discharge line.

22. The dispensing apparatus of one of claims 6 and 21 wherein said substrate is comprised of a material selected from a metal, a metal silicide, a metal carbide, a metal nitride, a semiconductor, an insulator and a barrier material.

23. The dispensing apparatus of claim 22 wherein said substrate is a patterned wafer.

## Patentansprüche

1. Vorrichtung zur Abgabe eines Reagens mit:
einem Behälter, der ein oberes Wandteil, ein Seitenwandteil und ein unteres Wandteil aufweist, die konfiguriert sind, um ein inneres Behälterabteil zu bilden, um eine Quellenchemikalie bis zu einem Füllpegel zu halten und zusätzlich ein inneres Gasvolumen oberhalb des Füllpegels festzulegen;
wobei das obere Wandteil eine erste Flächenabdichtanschlussöffnung (210), eine zweite Flächenabdichtanschlussöffnung (110) und optional eine oder mehrere weitere Flächenabdichtanschlussöffnungen aufweist;
wobei die erste Flächenabdichtanschlussöffnung ein erstes Anschlussstück (200) aufweist, das mit dieser verbunden ist und als Trägergaszufuhreinlassanschlussstück oder als Flüssigphasenreagensauslassanschlussstück dient;
einem Adapter (220) mit einer Metallflächenabdichtdichtung, die mit einem Rohr verbunden ist, welches sich durch die erste Flächenabdichtungsanschlussöfnung und das innere Gasvolumen hindurch in die Quellenchemikalie erstreckt und durch welches ein Trägergas in die Quellenchemikalie eingesprudelt werden kann, um dafür zu sorgen, dass mindestens ein Teil von Quellenchemikaliendampf in dem Trägergas mitgerissen wird, um einen Strom von Gasphasenreagens zu dem inneren Gasvolumen oberhalb des Füllpegels zu erzeugen, oder durch welches ein Flüssigphasenreagens aus der Vorrichtung ausgleitet werden kann, wobei das Rohr ein erstes Ende (221) benachbart zu der ersten Flächenabdichtungsanschlussöfnung und ein zweites Ende (224) benachbart zu dem unteren Wandteil aufweist;
wobei die erste Flächenabdichtanschlussöffnung und das erste Anschlussstück gegenüberliegende Oberflächen aufweisen;
Befestigungsmitteln (230, 240) zum Anbringen des ersten Anschlussstücks in der ersten Flächenabdichtanschlussöffnung durch die gegenüberliegenden Oberflächen und die Metallflächenabdichtungsdichtung hindurch; und
wobei die zweite Flächenabdichtanschlussöffnung ein zweites Anschlussstück (100) aufweist, welches mit dieser verbunden ist und bei welchem es sich um ein Gasphasenreagensauslassanschlussstück handelt, durch welches das Gasphasenreagens aus der Vorrichtung ausgeleitet werden kann oder bei welchem es sich in dem Fall, dass das erste Anschlussstück als ein Flüssigphasenreagensauslassanschlussstück dient, um ein Trägergaszufuhreinlassanschlussstück handelt, durch welches ein Trägergas in das innere Gasvolumen oberhalb des Füllpegels zugeführt werden kann, um das innere Gasvolumen oberhalb des Füllpegels unter Druck zu setzen, **dadurch gekennzeichnet, dass**
die gegenüberliegenden Oberflächen der ersten Flächenabdichtanschlussöfnung und des ersten Anschlussstücks nicht in Kontakt miteinander stehen und die Metallflächenabdichtdichtung zu den gegenüberliegenden Oberflächen der ersten Flächenabdichtanschlussöffnung und des ersten Anschlussstücks ausgerichtet ist und im Kontakt mit diesem steht.

2. Abgabevorrichtung gemäß Anspruch 1, wobei das Rohr (220) ein Sprudelrohr aufweist und aus rostfreiem Stahl gefertigt ist.

3. Abgabevorrichtung gemäß Anspruch 1, ferner versehen mit:
einer Trägergaszufuhrleitung, die sich außerhalb des ersten Anschlussstücks (200) zwecks Abgabe von Trägergas in die Quellenchemikalie erstreckt und eines oder mehrere Trägergasströmungssteuerventile zum Steuern des Durchstroms des Trägergases aufweist; und
einer Gasphasenreagensausgabeleitung, die sich außerhalb des zweiten Anschlussstücks (100) zwecks Abziehen von Gasphasenreagens aus dem inneren Gasvolumen oberhalb des Füllpegels erstreckt und optional eines oder mehrere Gasphasenreagensstromsteuerventile zum Steuern des Durchstroms des Gasphasenreagens aufweist.

4. Abgabevorrichtung gemäß Anspruch 3, wobei die Gasphasenreagensausgabeleitung in Gasphasenreagensströmungsverbindung mit einem Gasphasenabgabeabscheidungssystem steht, bei welchem es sich um ein CVD-Beschichtungssystem oder ein Atomlagenbeschichtungssystem handelt.

5. Abgabevorrichtung gemäß Anspruch 3, ferner versehen mit einer an die Trägergaszufuhrleitung gekoppelten Trägergasquelle.

6. Abgabevorrichtung gemäß Anspruch 3, mit:
einer Abscheidekammer, bei der es sich um eine CVD-Kammer oder eine Atomlagenabscheidekammer handelt;
wobei die Gasphasenreagensabgabeleitung die Gasphasenreagensabgabevorrichtung mit der Abscheidekammer verbindet;
optional einem heizbaren Suszeptor, der innerhalb der Abscheidekammer in einer Aufnahmebeziehung bezüglich der Gasphasenreagensausgabeleitung angeordnet ist; und
einer Abflussausgabeleitung, die mit der Abscheidekammer so verbunden ist, dass das Gasphasenreagens durch die Gasphasenreagensausgabeleitung hindurch geleitet wird und in die Abscheidekammer zwecks Kontakt mit einem Substrat, vorzugsweise auf dem heizbaren Suszeptor, geleitet wird, wobei jeglicher verbleibender Abfluss durch die Abflussabgabeleitung ausgeleitet wird.

7. Abgabevorrichtung gemäß Anspruch 1, wobei der Behälter aus rostfreiem Stahl gefertigt ist.

8. Abgabevorrichtung gemäß Anspruch 1, wobei das Rohr ein Tauchrohr aufweist und aus rostfreiem Stahl gefertigt ist.

9. Abgabevorrichtung gemäß Anspruch 1, wobei die Befestigungsmittel den Eingriff eines Gewindebolzens (230) oder eines Body-Hex-Bolzens mit einer Mutter (240) beinhaltet.

10. Abgabevorrichtung gemäß Anspruch 1, mit:
einer Inertträgergaszuführleitung, die sich außerhalb des ersten Anschlussstücks zwecks Zufuhr von Inertträgergas zu dem inneren Gasvolumen oberhalb des Füllpegels erstreckt und eines oder mehrere Inertgasstromsteuerventile zum Steuern des Durchstroms von Inertträgergas aufweist; und
einer Flüssigphasenreagensausgabeleitung, die sich außerhalb des zweiten Anschlussstücks zwecks Abziehen von Flüssigphasenreagens von dem Behälter erstreckt und optional eines oder mehrere Flüssigphasenreagensstromsteuerventile zwecks Steuern des Durchstroms des Flüssigphasenreagens enthält.

11. Abgabevorrichtung gemäß Anspruch 1, wobei das untere Wandteil einen Sumpfhohlraum aufweist, welcher sich von der Oberfläche des unteren Wandteils nach unten erstreckt.

12. Abgabevorrichtung gemäß Anspruch 11, mit:
einem Temperatursensor, der sich von dem oberen Randteil allgemein senkrecht nach unten durch das innere Gasvolumen hindurch in die Quellenchemikalie erstreckt, wobei das untere Ende des Temperatursensors in nicht-störender Nähe zu der Oberfläche des Sumpfhohlraums angeordnet ist;
einem Quellenchemikalienpegelsensor, der sich von einer dritten Flächenabdichtanschlussöffnung auf dem oberen Wandteil allgemein senkrecht nach unten durch das innere Gasvolumen hindurch in die Quellenchemikalie erstreckt, wobei das untere Ende des Quellenchemikalienpegelsensors in nicht-störender Nähe zu der Oberfläche des Sumpfhohlraums angeordnet ist; und
wobei der Temperatursensor in Wirkverbindung in dem Behälter angeordnet ist, um die Temperatur des Quellenchemikalie in dem Behälter zu bestimmen, wobei der Quellenchemikalienpegelsensor in Wirkverbindung in dem Behälter angeordnet ist, um den Pegel der Quellenchemikalie in dem Behälter zu bestimmen, wobei der Temperatursensor und der Quellenchemikalienpegelsensor in nicht-störender Nähe zueinander in dem Behälter angeordnet sind, wobei das untere Ende des Temperatursensors in der gleichen oder in näherer Nähe zu der Oberfläche des Sumpfhohlraums in Beziehung zu dem unteren Ende des Quellenchemikalienpegelsensors angeordnet ist, und wobei der Temperatursensor und der Quellenchemikalienpegelsensor in Quellenchemikalienströmungsverbindung in dem Behälter angeordnet sind.

13. Abgabevorrichtung gemäß Anspruch 10, wobei die Flüssigphasenreagensausgabeleitung in Flüssigphasenreagensströmungsverbindung mit einer Verdampfungsvorrichtung steht, die in Dampfphasenreagensströmungsverbindung mit einem Dampfphasenzufuhrabscheidesystem steht, bei welchem es sich um ein CVD-System oder ein Atomlagenabscheidesystem handelt.

14. Abgabevorrichtung gemäß Anspruch 1, wobei der Behälter ein zylindrisch geformtes Seitenwandteil oder Seitenwandteile aufweist, die eine nicht zylindrische Form festlegen.

15. Abgabevorrichtung gemäß Anspruch 1, wobei die Quellenchemikalie flüssiges oder festes Material aufweist.

16. Abgabevorrichtung gemäß Anspruch 1, wobei die Quellenchemikalie eine flüssige oder feste Vorstufe für ein Metall aufweist, welches aus der Gruppe 2, Gruppe 3, Gruppe 4, Gruppe 5, Gruppe 6, Gruppe 7, Gruppe 8, Gruppe 9, Gruppe 10, Gruppe 11, Gruppe 12, Gruppe 13, Gruppe 14, Gruppe 15, Gruppe 16 und der Lanthanidenreihe des Periodensystems ausgewählt ist.

17. Abgabevorrichtung gemäß Anspruch 1, wobei die Quellenchemikalie eine Vorstufe für ein Metall, bei dem es sich um Ruthenium, Hafnium, Tantal, Molybdän, Platin, Gold, Titan, Blei, Palladium, Zirkonium, Bismut, Strontium, Barium, Calcium, Antimon oder Thallium handelt oder eine Vorstufe für ein aus Silizium, Germanium und Tellur ausgewähltes Metalloid aufweist.

18. Abgabevorrichtung gemäß Anspruch 1, wobei das Gasphasenreagens eine Gasphasenvorstufe für ein Metall aufweist, welches aus der Gruppe 2, Gruppe 3, Gruppe, 4, gruppe 5, Gruppe 6, Gruppe 7, Gruppe 8, Gruppe 9, Gruppe 10, Gruppe 11, Gruppe 12, Gruppe 13, Gruppe 14, Gruppe 15, Gruppe 16 und der Lanthanidenreihe des Periodensystems ausgewählt ist.

19. Abgabevorrichtung gemäß Anspruch 1, wobei das Gasphasenreagens eine Vorstufe für ein Metall, bei welchem es sich um Ruthenium, Hafnium, Tantal, Molybdän, Platin, Gold, Titan, Blei, Palladium, Zirconium, Bismut, Strontium, Barium, Calcium, Antimon oder Thallium handelt oder eine Vorstufe für ein aus Silizium, Germanium und Tellur ausgewähltes Metalloid aufweist.

20. Abgabevorrichtung gemäß Anspruch 1, ferner versehen mit einer Inertgasquelle, die mit dem ersten Anschlussstück (200) gekoppelt ist.

21. Abgabevorrichtung gemäß Anspruch 1, ferner versehen mit:
einer Abscheidekammer, bei der es sich um eine CVD-Kammer oder eine Atomlagenabscheidekammer handelt;
eine Flüssigphasenreagensausgabeleitung, welche die Reagensabgabeleitung mit einer Verdampfungsvorrichtung verbindet;
wobei ein Teil der Verdampfungsvorrichtung eine Trägergaszufuhreinlassöffnung aufweist, durch welche Trägergas in die Verdampfungsvorrichtung eingeleitet werden kann, um dafür zu sorgen, dass Dampf des Flüssigphasexaxeagens in dem Trägergas mitgerissen wird, um ein Gasphasenreagens zu erzeugen;
wobei ein Teil der Verdampfungsvorrichtung eine Gasphasenreagensauslassöffnung aufweist, durch welche das Gasphasenreagens aus der Verdampfungsvorrichtung abgegeben werden kann;
einer Trägergaszufuhrleitung, welche sich von der Trägergaszufuhreinlassöffnung außerhalb von der Verdampfungsvorrichtung zwecks Zufuhr von Trägergas in die Verdampfungsvorrichtung erstreckt und ein Trägergasstromsteuerventil zum Steuern des Durchstroms des Trägergases enthält;
einer Gasphasenreagensausgabeleitung, die sich von der Gasphasenreagensauslassöffnung außerhalb von der Verdampfungsvorrichtung zwecks Abziehen des Gasphasenreagens von der Verdampfungsvorrichtung zu der Abscheidekammer erstreckt und ein Gasphasenreagensstromsteuerventil zum Steuern des Durchstroms der Gasphasenreagens enthält;
optional einem heizbaren Suszeptor, der in der Abscheidekammer enthalten und in einer Aufnahmebeziehung bezüglich der Verdampfungsvorrichtung angeordnet ist; und
einer Abflussauslassleitung, die mit der Abscheidekammer verbunden ist;
so dass das Gasphasenreagens durch die Gasphasenreagensausgabeleitung und in die Abscheidekammer zwecks Kontakt mit einem Substrat geleitet wird, welches optional auf dem heizbaren Suszeptor befindlich ist, und jeglicher verbleibende Ausfluss durch die Abflussausgabeleitung ausgeleitet wird.

22. Abgabevorrichtung gemäß einem der Ansprüche 6 und 21, wobei das Substrat von einem Material gebildet wird, bei dem es sich um ein Metall, ein Metallsilizid, ein Metallcarbid, ein Metallnitrid, einen Halbleiter, einen Isolator oder ein Barrierenmaterial handelt.

23. Abgabevorrichtung gemäß Anspruch 22, wobei es sich bei dem Substrat um einen strukturierten Wafer handelt.

## Revendications

1. Appareil de distribution de réactif comprenant :
un récipient qui comprend un élément formant paroi supérieure, un élément formant paroi latérale et un élément formant paroi inférieure configurés pour former un compartiment interne du récipient pour contenir un produit chimique source jusqu'à un niveau de remplissage et pour définir par ailleurs un volume interne de gaz au-dessus du niveau de remplissage ;
ledit élément formant paroi supérieure ayant une première ouverture (210) de passage d'une garniture d'étanchéité, une deuxième ouverture (110) de passage d'une garniture d'étanchéité et éventuellement une ou plusieurs autres ouvertures de passage de garnitures d'étanchéité ;
ladite première ouverture de passage d'une garniture d'étanchéité ayant un premier raccord (200) qui lui est relié et faisant office de raccord d'entrée d'alimentation en gaz porteur ou d'un raccord de sortie de réactif en phase liquide ;
un adaptateur (220) comprenant un joint d'étanchéité métallique relié à un tube qui s'étend à travers la première ouverture de passage d'une garniture d'étanchéité et ledit volume interne de gaz dans le produit chimique source et à travers lequel un gaz porteur peut être barboté dans le produit chimique source pour provoquer l'entraînement d'au moins une partie de la vapeur du produit chimique source dans ledit gaz porteur afin de produire un flux de réactif en phase vapeur audit volume interne de gaz au-dessus du niveau de remplissage ou un réactif en phase liquide peut être distribué à partir de l'appareil, ledit tube ayant une première extrémité (221) adjacente à la première ouverture de passage d'une garniture d'étanchéité et une deuxième extrémité (224) adjacente à l'élément formant paroi inférieure ;
ladite première ouverture de passage d'une garniture d'étanchéité et ledit premier raccord présentant des surfaces opposées ;
des moyens de fixation (230, 240) pour fixer ledit raccord à ladite première ouverture de passage d'une garniture d'étanchéité à travers les surfaces opposées et ledit joint d'étanchéité métallique ; et
ladite première ouverture de passage d'une garniture d'étanchéité ayant un deuxième raccord (100) qui lui est relié et qui est un raccord de sortie d'un réactif en phase vapeur, à travers lequel ledit réactif en phase vapeur peut être distribué dudit appareil, ou qui est, dans le cas où le premier raccord fait office de raccord de sortie d'un réactif en phase liquide, un raccord d'entrée d'une alimentation en gaz porteur à travers lequel un gaz porteur peut être alimenté dans le volume interne de gaz au-dessus du niveau de remplissage pour mettre sous pression le volume interne de gaz au-dessus du volume de remplissage, **caractérisé en ce que** :
lesdites surfaces opposées de la première ouverture de passage d'une garniture d'étanchéité et ledit raccord n'entrent pas en contact, et ledit joint d'étanchéité métallique s'aligne et est en contact avec lesdites surfaces opposées de ladite première ouverture de passage d'une garniture d'étanchéité et dudit raccord.

2. Appareil de distribution de la revendication 1, dans lequel le tube (220) constitue un tube de barbotage et est réalisé en acier inoxydable.

3. Appareil de distribution de la revendication 1, comprenant en outre :
une ligne d'alimentation en gaz porteur s'étendant à l'extérieur du premier raccord (200) pour distribuer un gaz porteur dans ledit produit chimique source, la ligne d'alimentation en gaz porteur contenant une ou plusieurs soupapes de commande du flux de gaz porteur pour commander le flux de gaz porteur à travers celle-ci ; et
une ligne d'évacuation de réactif en phase vapeur s'étendant à l'extérieur du deuxième raccord (100) pour retirer le réactif en phase vapeur dudit volume interne de gaz au-dessus du niveau de remplissage, la ligne d'évacuation de réactif en phase vapeur contenant éventuellement une ou plusieurs soupapes de commande du flux de réactif en phase vapeur pour commander un flux de réactif en phase vapeur à travers celle-ci.

4. Appareil de distribution de la revendication 3, comprenant en outre la ligne d'évacuation de réactif en phase vapeur en communication de flux de réactif en phase vapeur avec un système de dépôt d'une distribution en phase vapeur, ledit système de dépôt étant sélectionné parmi un système de dépôt chimique en phase vapeur ou un système de dépôt de couches atomiques.

5. Appareil de distribution de la revendication 3, comprenant en outre une source de gaz porteur couplée à la ligne d'alimentation en gaz porteur.

6. Appareil de distribution de la revendication 3, comprenant en outre :
une chambre de dépôt choisie parmi une chambre de dépôt chimique en phase vapeur et une chambre de dépôt de couches atomiques.
la ligne d'évacuation de réactif en phase vapeur reliant l'appareil de distribution de réactif à la chambre de dépôt ;
éventuellement un suscepteur pouvant être chauffé contenu dans la chambre de dépôt et se trouvant en relation de réception vis-à-vis de la ligne d'évacuation de réactif en phase vapeur ; et
une ligne d'évacuation d'effluent reliée à la chambre de dépôt ;
de sorte que le réactif en phase vapeur passe à travers la ligne d'évacuation de réactif en phase vapeur et dans la chambre de dépôt, pour entrer en contact avec un substrat, éventuellement sur le suscepteur pouvant être chauffé, et tout effluent restant est déchargé à travers la ligne d'évacuation d'effluent.

7. Appareil de distribution de la revendication 1, dans lequel le récipient est réalisé en acier inoxydable.

8. Appareil de distribution de la revendication 1, dans lequel le tube constitue un tube plongeur et est réalisé en acier inoxydable.

9. Appareil de distribution de la revendication 1, dans lequel les moyens de fixation comprennent un engagement d'un écrou mâle (230) ou d'un corps hexagonal avec un écrou femelle (240).

10. Appareil de distribution de la revendication 1, comprenant en outre :
une ligne d'alimentation en gaz porteur inerte s'étendant à l'extérieur du premier raccord pour distribuer un gaz porteur inerte dans ledit volume interne de gaz au-dessus du niveau de remplissage, la ligne d'alimentation en gaz porteur inerte contenant une ou plusieurs soupapes de commande du flux de gaz porteur inerte pour commander le flux de gaz porteur inerte à travers celle-ci : et
une ligne d'évacuation de réactif en phase liquide s'étendant extérieurement depuis le deuxième raccord (100) pour retirer le réactif en phase liquide dudit récipient, la ligne d'évacuation de réactif en phase liquide contenant éventuellement une ou plusieurs soupapes de commande du flux de réactif en phase liquide pour commander le flux de réactif en phase liquide à travers celle-ci.

11. Appareil de distribution de la revendication 1, dans lequel ledit élément formant paroi inférieure présente une cavité de collecte s'étendant vers le bas depuis la surface dudit élément formant paroi inférieure.

12. Appareil de distribution de la revendication 11, comprenant en outre :
un capteur de température s'étendant depuis ledit élément formant paroi supérieure de manière globalement verticale et descendante à travers le volume interne de gaz dans le produit chimique source, avec l'extrémité inférieure du capteur de température située à proximité de la surface de la cavité de collecte sans la toucher :
un capteur de niveau de produit chimique source s'étendant d'une troisième ouverture de passage d'une garniture d'étanchéité sur ledit élément formant paroi supérieure de manière globalement verticale et descendante à travers le volume interne de gaz dans le produit chimique source, avec l'extrémité inférieure du capteur de niveau de produit chimique source située à proximité de la surface de la cavité de collecte sans la toucher ; et
le capteur de température étant agencé de manière fonctionnelle dans le récipient afin de déterminer la température du produit chimique source dans le récipient, le capteur de niveau de produit chimique source étant agencé de manière fonctionnelle dans le récipient afin de déterminer le niveau du produit chimique source dans le récipient, le capteur de température et le capteur de niveau de produit chimique source étant situés l'un à proximité de l'autre dans le récipient sans se toucher, avec l'extrémité inférieure du capteur de température située aussi proche ou plus proche de la surface de la cavité de collecte par rapport à l'extrémité inférieure du capteur de niveau de produit chimique source, et le capteur de température et le capteur de niveau de produit chimique source étant en communication de flux de produit chimique source dans le récipient.

13. Appareil de distribution de la revendication 10, comprenant en outre la ligne d'évacuation de réactif en phase liquide en communication de flux de réactif en phase liquide avec un appareil de vaporisation, ledit appareil de vaporisation étant en communication de flux de réactif en phase vapeur avec un système de dépôt et de distribution en phase vapeur, ledit système de dépôt étant choisi parmi un système de dépôt chimique en phase vapeur et un système de dépôt de couches atomiques.

14. Appareil de distribution de la revendication 1, dans lequel le récipient comprend un élément formant paroi latérale de forme cylindrique ou des éléments de paroi latérale définissant une forme non cylindrique.

15. Appareil de distribution de la revendication 1, dans lequel le produit chimique source comprend un matériau liquide ou solide.

16. Appareil de distribution de la revendication 1, dans lequel le produit chimique source comprend un précurseur solide ou liquide pour un métal sélectionné à partir du Groupe 2, Groupe 3, Groupe 4, Groupe 5, Groupe 6, Groupe 7, Groupe 8, Groupe 9, Groupe 10, Groupe 11, Groupe 12, Groupe 13, Groupe 14, Groupe 15, Groupe 16, et de la série des lanthanides du tableau périodique.

17. Appareil de distribution de la revendication 1, dans lequel le produit chimique source comprend un précurseur pour un métal choisi parmi le ruthénium, l'hafnium, le tantale, le molybdène, le platine, l'or, le titane, le plomb, le palladium, le zirconium, le bismuth, le strontium, le baryum, le calcium, l'antimoine et le thallium, ou un précurseur pour un métalloïde choisi parmi le silicium, le germanium et le tellure.

18. Appareil de distribution de la revendication 1, dans lequel le réactif en phase vapeur comprend un précurseur en phase vapeur pour un métal sélectionné à partir du Groupe 2, Groupe 3, Groupe 4, Groupe 5, Groupe 6, Groupe 7, Groupe 8, Groupe 9, Groupe 10, Groupe 11, Groupe 12, Groupe 13, Groupe 14, Groupe 15, Groupe 16, et de la série des lanthanides du tableau périodique.

19. Appareil de distribution de la revendication 1, dans lequel le réactif en phase vapeur comprend un précurseur pour un métal choisi parmi le ruthénium, l'hafnium, le tantale, le molybdène, le platine, l'or, le titane, le plomb, le palladium, le zirconium, le bismuth, le strontium, le baryum, le calcium, l'antimoine et le thallium, ou un précurseur pour un métalloïde choisi parmi le silicium, le germanium et le tellure.

20. Appareil de distribution de la revendication 1, comprenant en outre une source de gaz inerte couplée au premier raccord (200).

21. Appareil de distribution de la revendication 1, comprenant en outre :
une chambre de dépôt choisie parmi une chambre de dépôt chimique en phase vapeur et une chambre de dépôt de couches atomiques ;
une ligne d'évacuation de réactif en phase liquide reliant l'appareil de distribution de réactif à un appareil de vaporisation ;
une partie de l'appareil de vaporisation ayant une ouverture d'entrée d'alimentation en gaz porteur à travers laquelle un gaz porteur peut être alimenté audit appareil de vaporisation pour provoquer l'entraînement de la vapeur dudit réactif en phase liquide dans ledit gaz porteur afin de produire un réactif en phase vapeur ;
une partie de l'appareil de vaporisation ayant une ouverture d'évacuation de réactif en phase vapeur à travers laquelle ledit réactif en phase vapeur peut être distribué dudit appareil de vaporisation ;
une ligne d'alimentation en gaz porteur s'étendant de l'ouverture d'entrée d'alimentation en gaz porteur extérieurement depuis l'appareil de vaporisation pour distribuer un gaz porteur dans ledit appareil de vaporisation, la ligne d'alimentation en gaz porteur contenant une soupape de commande de flux de gaz porteur pour commander le flux de gaz porteur à travers aelle-ci ;
une ligne d'évacuation de réactif en phase vapeur s'étendant de l'ouverture de sortie de réactif en phase vapeur extérieurement depuis l'appareil de vaporisation pour retirer le réactif en phase vapeur dudit appareil de vaporisation vers ladite chambre de dépôt, la ligne d'évacuation de réactif en phase vapeur contenant une soupape de commande de flux de réactif en phase vapeur pour commander le flux de réactif en phase vapeur à travers celle-ci ;
éventuellement un suscepteur pouvant être chauffé contenu dans la chambre de dépôt et se trouvant dans une relation de réception par rapport à l'appareil de vaporisation ; et
une ligne d'évacuation d'effluent reliée à la chambre de dépôt ;
de sorte que le réactif en phase vapeur passe à travers la ligne d'évacuation de réactif en phase vapeur et dans la chambre de dépôt, pour entrer en contact avec un substrat, éventuellement sur le suscepteur pouvant être chauffé, et tout effluent restant est déchargé à travers la ligne d'évacuation d'effluent.

22. Appareil de distribution de l'une des revendications 6 et 21, dans lequel ledit substrat est composé d'un matériau choisi parmi un métal, un siliciure métallique, un carbure métallique, un nitrure métallique, un semi-conducteur, un isolant et un matériau barrière.

23. Appareil de distribution de la revendication 22, dans lequel ledit substrat est une plaquette à motifs.
